# EUROPEAN PATENT APPLICATION

(11) **EP 4 841 494 A1**
(43) Date of publication of application: **18.11.2026**
(21) Application number: 25382475.9
(22) Date of filing: 12.05.2025
(51) Int. Cl.: G06F 30/15, G06F 30/20

(54) **A COMPUTER IMPLEMENTED METHOD FOR DETERMINING A FAILURE CONDITION FOR AN APPARATUS**

(71) Applicant: AIRBUS OPERATIONS, S.L.U., 28906 Getafe, Madrid (ES)
(72) Inventor: PARDO LÓPEZ, Abel, E-28906 Getafe, Madrid (ES); MANCEBO ORDÓÑEZ, Fernando, E-28906 Getafe, Madrid (ES); MATEOS CEPEDA, Carlos, E-28906 Getafe, Madrid (ES); MONTES SALMERÓN, Alberto, E-28906 Getafe, Madrid (ES)
(74) Representative: ABG Intellectual Property Law, S.L.

(57) **Abstract**

A method for determining a failure condition for an apparatus is related to the field of airframe design and structural verification. The method is directed to compute a convex domain named convex hull of a set of variables related to a plurality of loads and/or actions acting on the structure satisfying that for any set of variables located within the convex hull, the design of said structure provides a reliable structure under any of the conditions it is subjected to and which are within the convex hull.

## Description

### FIELD OF THE INVENTION

The present invention is related to the field of airframe design, structural integrity analysis and verification.

A computer implemented method is directed to compute a convex domain named convex hull of a set of variables related to a plurality of loads and/or actions acting on the structure satisfying that any set of variables located within the convex hull, the design of said structure does not fail. The resulting tested structure is a reliable structure in the sense that, under any of the conditions it is subjected to and which are within the convex hull, it will be a faultless structure with no need of carrying out further numerical or physical experiments.

### PRIOR ART

One of the areas of technology that is currently of greatest interest is that of verifying whether complex structures give rise to failure in any of the possible situations to which they are subjected under operational conditions.

These complex structures are subjected to a wide range of external actions.

When verifying whether a pre-designed structure fails, whether by experimentation and/or by computer numerical simulation, it is usually necessary to determine a priori one of these external actions in order to calculate whether failure will occur.

Throughout the description, when talking about external actions, we will interpret it in the most generic sense as forces and energy sources acting on the structure. In particular, by way of example, external actions include: stresses, forces, pressures, temperature sources, etc., exerted on the structure and in most cases all these actions can be acting simultaneously.

In this description, external actions are manipulated by using vectors in which the variables that define these external actions are ordered. For example, if the external actions are a force variable, pressure and temperature, the force variable is a vector, pressure is a scalar value and temperature is also a scalar value. In this case, the components of the force are broken down into as many scalar values as the force has coordinates. In this way, the vector that defines the external action, in general terms would contain a first group of coordinates corresponding to the force variable, followed by a scalar corresponding to the pressure and finally a scalar for the temperature.

This way of ordering the variables is not unique but it allows them to be manipulated in a compact way.

The vector thus constructed will be identified along the description as a "load vector" and such vector is an element of a certain vectorial space. The load vector is defined by its coordinates. Since these coordinates also define a point in the same vector space, the load vector can be represented as the vector extending from the origin (zero vector) to that point. Therefore, "load vector" and "point in space" will be used interchangeably.

In mathematics there are different ways of representing variables and operating with them. In this description a specific way of describing the variables is chosen, however, the stages of the methods described do not depend on the way the variables are represented but on the operations that are carried out on them. Therefore, ways of operating on the values involved in the methods described that are the same, even if they are not represented in the same way, will be considered equivalent.

A specific example. Given a vector, its direction defines a line in a space. Any of the points on the line can be identified in different ways, for example as those points in space whose coordinates are constrained by the equations of the line. Another alternative way is to parameterize the line so that varying a scalar parameter gives a displacement along the line. By changing this parameter, the velocity of advance along the line can be varied, thus making it possible to find infinite ways of identifying points on the same line. However, any of the definitions relating to the definition of the geometric locus of the line is considered equivalent.

Additionally, when the method establishes conditions on any of the points on the line, the method is independent of these examples of representation of the points on the line, hence, ways of carrying out the method that make use of ways of representing the data differently are to be interpreted as equivalent.

In the field of numerical computation, external actions together with boundary conditions are what determine the response of the structure once its design and properties such as the materials and specific configuration of its parts have been established.

It is known that a set of load vectors, when applied to a given structure without causing failure, defines a convex space. This space is bounded by hyperplanes connecting the points representing these load vectors. Any load vector represented by a point within this convex space is also a safe load; that is, it will not cause structural failure. These hyperplanes are sometimes referred to as hyper-faces when limited to the region being the boundary of the convex space.

Algorithms exist for constructing convex hulls in two and three dimensions. While some algorithms have been proposed for higher dimensions, they exhibit instability and high computational cost, limiting their practical use for real cases.

A significant challenge arises from the resources required to determine the failure condition for a given load vector. Physical experimentation demands substantial resources for constructing the structure and applying loads, in addition to significant time investment. Modifying any variable necessitates repeating the entire experiment, including rebuilding the structure if a failure occurs.

Numerical simulation, while an alternative, also incurs high computational costs. Complex numerical models, often employing finite element methods with a large number of nodes, are required to accurately represent the relevant physical phenomena. This complexity results in long simulation times and substantial computational expense for each load case.

From an engineering point of view, therefore, a first question arises of how to establish a family of external actions which, when tested on a determined structure or apparatus, cover the widest possible range of real situations, giving confidence about the safety of the structure also under other actions to which it will be subjected that are limited in some way.

### DESCRIPTION OF THE INVENTION

A first aspect of the invention is a computer implemented method for determining a failure condition for an apparatus subjected to load or action (*lₜ*) actuating on the apparatus.

The method comprises:
- *inputting data into a computer system, the inputted data representing m known loads or actions (l) acting on the apparatus satisfying:*
   *said m loads or actions (l) results in a status of non-failure,*
   *said data being stored as set of m vectors* ( ${v}_{j} ∈ {ℝ}^{n}$; *j =* 1, ..., *m) and wherein n is the number of coordinates, each coordinate defining each scalar value of the individual load or action (l);*
   *the number of vectors m is larger than n and, the rank of the set of vectors is n;*
- *computing by the computer system a domain (* $D ⊂ {ℝ}^{n}$*) delimited by a safe convex hull defined by a plurality of hyperplanes, the convex hull calculated according to the following steps:*
   *a) determining a first convex domain (D̃), preferably as an octahedron with hyper-faces defined by max-min points;*
   *b) removing those vectors (vⱼ) located within the calculated convex domain (D̃);*
   *c) grouping the set of vectors (vⱼ) that have not been removed in the previous step, one group per hyper-face delimiting the calculated convex domain (D̃), wherein each group (Gⱼ) comprises those vectors (vⱼ) which has intersection in the part of the hyper-face that belongs to the calculated convex domain (D̃);*
   *d) for each group (Gⱼ), selecting the vector (vⱼ) which has the greatest distance to the corresponding hyper-face of the convex domain (D̃) and, replacing the corresponding hyper-face by a set of new hyper-faces passing through the point defined by the vector (vᵢ) of greatest distance and lying on the boundaries of the replaced corresponding hyper-face which belong to the calculated convex domain (D̃) before being substituted;*
   *e) iterating from step b) until convergence, that is, until there are no more vectors (vⱼ) located outside of the calculated convex domain (D̃), and wherein the convex hull is the resulting calculated convex domain D̃ after convergence;*
- *checking if the load or action* (*lₜ*) *lies within the convex hull determining a failure condition, where the status is deemed a non-failure condition if the load or action* (*lₜ*) *is within the convex hull, and a failure condition otherwise.*

The first step is the input of data that must be generated from the values of actions to be applied to the apparatus. The apparatus can be the apparatus that is the object of the design or, also, an intermediate apparatus designed to verify simplified models of a specific structural behavior that, once tested, allows inferring how the design of the original apparatus should be. For example, if a skilled person in the design of the apparatus wishes to analyze the failures of a certain rivet or joining element that exists in a plurality of parts of the original apparatus, it is possible to design a simple experiment with only one of those joining elements in order to infer the behavior in all of them, reducing the computer cost.

However, even in this intermediate apparatus the number of experiments to be tested can be very high given that it must be tested under any condition, such as stress, pressure, different temperature ranges, etc. A common case is the verification of the joints in the ribs of an airplane wing, which have an order of magnitude between 10⁵ and 10⁶, all verified under several thousand maneuvering conditions.

Once the apparatus on which the no-failure conditions are to be established has been defined, a finite set of load vectors is sought. As described above, the vector is a predetermined arrangement of scalar values where, for variables that are already vectorial, these vectorial variables contribute to the load vector with each of their scalar components.

These load vectors must be tested on the apparatus to verify that they do not give rise to failure. This verification can be carried out directly on a prototype or by simulating the apparatus reproduced as a numerical model. An example of a numerical model is a model that represents, using the finite element method, the shape of the set of elements that make up the apparatus and as a method of approximating the solution **by solving** the differential equations that model its behavior when the apparatus is subjected to the conditions defined by the load vector.

Finally, it is necessary that the number of load vectors used, m, at the input is greater than its dimension, n, understanding that the selected vectors are linearly independent. It is also required that the rank of the set of vectors be n, ensuring that they form a generating system of an n-dimensional space.

The expression ( ${v}_{j} ∈ {ℝ}^{n}$; j = 1, ..., *m*) should be interpreted as a set of vectors, in particular m vectors, each with *n* coordinates given that it is a vector of ${ℝ}^{n}$. The subscripts are mute so the specific letter used in the subscript does not establish any limitation on the method and simply establishes the way to go through the whole set and how to specify a vector individually, if necessary.

The next step is an iterative method in which, initially a domain or a region of the space of *Rⁿ* is constructed that verifies to be convex, under some minimum conditions, and then iteratively extending this domain to a larger domain always maintaining the condition of being convex.

The convexity condition is essential for this method since it ensures that, each time the domain is expanded, any load vector that lies in the convex domain verifies to be a load that does not cause failure in the apparatus.

The first domain is constructed in a simple way, for example by determining a first domain as an octahedron with hyper-faces defined by max-min points at each of the coordinates of the set of vectors.

The domain finally computed does not depend on how the first convex domain is selected.

The first generated domain is convex and the condition can be given that some of the input vectors lie within the domain. This subset of vectors that is already inside the first domain is removed since further expansion of the domain will be carried out using the vectors that are outside the domain.

The remaining subset of vectors, according to the next stage within the iterative loop, is grouped where, each group of vectors verifies that it is a vector intersecting the same hyper-face.

Those hyper-faces that have a group of one or more associated vectors, the vectors intersecting the hyper-face, are the hyper-faces that are modified in the expansion phase. In particular, from the subset of vectors of the same group intersecting the hyper-face, the one with the largest distance to the hyper-face is selected. The distance is measured having predefined a norm and therefore having predefined a scalar product. An example of a norm is the Euclidean norm derived from the usual scalar product.

If two or more vectors show the same distance to the hyper-face then one of them is selected, for example randomly, although it has been proven that it is very rare to arrive at two vectors having exactly the same distance to the hyper-face.

The selected vector defines a point in space outside the generated domain. The expansion of this domain is carried out by replacing the hyper-face by a plurality of hyper-faces that verify to contain the point defined by the selected vector and that support the boundaries that delimited the removed hyper-face.

The set of new hyper-faces are outside the domain so the volume formed by the domain located between the new hyper-faces and the hyper-face that has been removed is an additional volume that has caused an expansion and also verifies that the new expanded domain is convex.

In this new expanded domain, the set of vectors that has allowed to select a vector, the one with the largest distance to the hyper-face, can now also show a subset of vectors that is still outside the new expanded domain. Hence, the method is iterative and proceeds again from the stage of removing vectors that are already inside the expanded domain to re-group vectors that are outside the domain under the criterion of having intersection with the same hyper-face and repeating the process.

According to a specific example that optimizes this process, in this new grouping it is not necessary to determine groups of vectors intersecting faces that have not been modified, so the action of grouping is limited to the vectors that were previously in the hyper-face that has been replaced by a plurality of new hyper-faces. The grouping will therefore check for each vector of this subgroup which new hyper-faces it intersects to establish new subgroups of vectors to be added to the groups of vectors that have not caused a change in the expanded domain.

The domain obtained after the convergence of the iterative method is a convex domain that is identified as a convex hull.

In an embodiment according to the method previously disclosed, *in step e), a vector (vⱼ) is located outside of the calculated convex domain (D̃), if the distance of the vector (vⱼ) to the closest hyper-face is higher than a predetermined threshold, preferably of 20%, preferably of 10%, more preferably of 5%, more preferably of 3%, more preferably of 2% and more preferably of 1%.*

The use of a threshold value in this part of the method has a strong impact on the computer cost since all those vectors that, even being outside the convex domain, their distance to the hyperplane is below the threshold value are not going to be vectors that cause a new calculation that would incur the need to determine a plurality of new hyper-faces and regrouping of vectors. In the practical cases it has been proven that the impact of using an adequate threshold value can reduce the number of vectors to be processed by more than 40% and, in certain specific cases, by more than 90%.

Another way of looking at this reduction of the computational cost is to see it as a specific way of accelerating the convergence of the iterative method.

In an embodiment according to any of the methods previously disclosed, *the inputted data representing m known loads or actions (l) acting on the apparatus are retrieved from:*
- *measurements;*
- *results of simulations;*
- *a data base storing any of the two former sources;*
- *a combination of any of the previous one.*

The load vectors, according to an embodiment come from load tests on physical prototypes. Another source of data are simulations on a numerical model representing the physical apparatus. Any of these data can be previously stored in a database that is subsequently used by selecting those values that are relevant for the design of the section to be subjected under test loads.

In an embodiment according to any of the methods previously disclosed, the method further comprises:
- *instantiating into the computer system a simulation module implementing a numerical model adapted to simulate the behavior of at least one part of the apparatus, the module providing at least one status variable responsive to a failure condition of the simulated apparatus when subjected to a load or action (l)*;
- *inputting one or more loads or actions (l);*
- *simulating the behavior of the at least one part of the apparatus subjected to the inputted one or more loads or actions (l) by means of the simulation module;*
- *providing those loads or actions resulting in a non-failure condition as inputted data for determining the convex hull.*

According to this example of embodiment, once the design of the apparatus has been defined, the method makes use of a simulation module that implements a numerical model that simulates the behavior of the apparatus according to the physics involved in the response of the apparatus to the action of a load vector.

For example, if the load vector includes loads on a structure and heat sources that cause thermal expansion in that structure, then the numerical model incorporates an approximation model of the elasticity equations, the heat conduction equations and additional coupling conditions between both set of equations.

One example of an approximation method for solving these equations is the finite element method, which not only establishes the numerical solution of these equations but also allows the shape of any of the parts to be approximated with great flexibility.

Other alternative methods are finite volume methods, finite difference methods or spectral methods.

The simulation module is adapted to receive a load vector, carry out the simulation of the apparatus and establish whether or not the apparatus fails.

The method according to this example receives a plurality of load vectors for which there is no information on how the apparatus behaves, simulates one or more of them and keeps those which, having been simulated, verify that the simulation does not result in apparatus failure.

It is these load vectors that do not result in apparatus failure that are introduced into the method described to determine the convex hull.

In an embodiment according to any of the methods previously disclosed, *the convex hull is expanded by carrying out the steps:*
*i. a ratio is defined as* $Rt \left({v}_{j}\right) = \frac{\left‖{v}_{j}\right‖}{\left‖{v}_{j}^{fail}\right‖}$ *wherein* ∥·∥ *is a predetermined norm, vⱼ is a load and* ${v}_{j}^{fail}$ *is a load having the same direction as vⱼ such that* $\left‖{v}_{j}^{fail}\right‖ = \left‖{λ}_{0}{v}_{j}\right‖$ *for λ*₀ *a scalar value satisfying that vectors λvⱼ for λ > λ*₀ *results in a fail status condition and, for λ* ≤ *λ*₀ *results in a non-fail status condition, that is, Rt*(*vⱼ*) *is less or equal than 1 when the load does not cause a failure and greater than 1 when the load causes a failure.;*
*ii. selecting a subset of k vectors (vₖ) among the m vectors (vⱼ);*
*iii. for each selected vector (vₖ) determining a new vector (vₖ) satisfying that Rt*(*ṽₖ*) *= λ* and that ṽₖ = λvₖ being λ a non zero scalar, wherein λ* is 1, or more preferably 1 minus a positive predetermined threshold;*
*iv. replacing vₖ by ṽₖ and further expanding the convex hull by iterating steps b) to e).*

The convex hull is a convex space that ensures that any action defined by a load vector located inside the convex space and applied to the apparatus will not result in failure. However, there is a convex space that completely contains the calculated convex hull that also verifies that any action defined by a load vector located inside it also results in a no-failure condition. However, this larger space is unknown.

Therefore, there are load vectors located in the larger convex space that are not in the calculated convex hull that define actions that, when applied to the apparatus, also do not give rise to failure. A design that takes these vectors into account outside the convex hull calculated by the method described using only the first load vectors is not an optimal design.

In this embodiment, an expansion of the convex hull is carried out that is still safe, that is, part of the space outside the calculated convex hull is explored, which determines regions in which the failure is not verified by simulation and which continue to define a safe convex space.

The specific way of carrying out this expansion is to explore along specific directions outside the calculated convex hull.

Initially a specific norm is established with which to measure distances. According to a preferred example, the same norm is used as that used in the generation of the precalculated convex hull.

The defined ratio is a scalar quotient of two scalars, the norm of a load vector divided by the norm of the load vector from which failure occurs.

At all times the exploration is going to be carried out along a certain direction that passes through the origin, that is, along the direction of a certain load vector.

Hence, in that direction, along the line passing through the origin and in the direction of the load vector, the point from which failure occurs is explored. The vector determined by that point is ${v}_{j}^{fail}$*.*

Therefore, *Rt*(*vⱼ*) is verified to be less than 1 when a load vector according to the direction of the line does not cause failure and does cause it in any other case.

From the m vectors initially used to generate the calculated convex hull, a subset of *k* vectors is selected that is used to determine the directions to be explored. That is, of the infinite points outside the calculated convex hull, only a finite set of directions are explored, drastically reducing the computer cost.

For each direction of this selected subset of load vectors, the point on the line in which the ratio *Rt*(*vⱼ*) is 1 or 1 minus a threshold value is explored to determine a safety margin before failure occurs in that same direction.

This step is carried out for each of the selected vectors, resulting in new vectors in the same direction but determining points outside the previously calculated convex hull.

Based on these new vectors, the iterative method is applied again, grouping according to the criterion of belonging to the same hyper-face, determining for each group the vector furthest from the hyper-face and substituting the associated hyper-face for a plurality of hyper-faces that pass through the point determined by the extended vector and the boundary defined by the hyper-face that is removed.

The result is a specific method in which the convex hull is larger, which continues to verify being a convex space and which contains a larger set of vectors in many directions that have not been simulated, reducing the computational cost, thanks to having previously selected directions along which it has been explored outside the initial convex hull.

It is important to emphasize that, although only a finite set of directions have been explored, the expansion of the convex hull occurs in many other directions as a result of "moving" the hyper-faces that are in contact with the vector used to explore its direction.

The new convex hull is a space that is verified as containing load vectors that do not cause the apparatus to fail and is obtained at a reduced computer cost. This expanded convex hull provides a more efficient computational process during the verification of a design and when checking the structural integrity of said design.

In an embodiment according to any of the methods previously disclosed, *before step a), carrying out steps ii) iv) and, replacing vₖ by ṽₖ.*

In the embodiment described above, once a first convex hull has been calculated, directions are selected in which to explore outside the convex hull, searching for vectors in the same direction until a length is reached where the fault occurs or is close to occurring.

According to this embodiment, this exploration along one or more directions established by the initial vectors is carried out before starting with the first convex domain so that the iterative method already takes into account vectors further away from the origin and, in a single iterative method, a more expanded convex hull is obtained, also reducing the computer cost.

A second aspect of the invention is *an apparatus designed to be subjected to loads or actions actuating on the apparatus, tested according to any of the previously disclosed methods, and satisfying that the status of the tested design is 'non-failure'.*

The apparatus, according to some examples, is an airplane or, according to another example, is an intermediate apparatus used to test conditions for a plurality of elements of an airplane. The apparatus that has been verified according to this second aspect of the invention is an apparatus that is considered either viable if the status determined by any of the described methods establishes it as "non-failure" or, otherwise, non-viable. The apparatus that has been determined as viable is of interest.

jA third aspect of the invention *is an apparatus, preferably an aircraft, comprising an alarm device adapted to carry out continuous sampling of the loads or actions acting on the apparatus, where the alarm device is activated when such loads or actions are located outside the convex hull determined by a method according to any one of the methods disclosed according to the first aspect of the invention.*

A fourth aspect of the invention *is an apparatus manufactured according to the tested design according to the second aspect of the invention.*

The design of an apparatus follows an iterative process of refinement according to many criteria, including structural, ergonomic, cost and even aesthetic criteria, etc. In the context of the invention, the design that meets the technical design criteria is that which at least has a result of the status determined according to any of the methods described according to the first aspect of the invention which is non-failure.

A fifth aspect of the invention is *a computer system adapted to carry out any of the disclosed methods according to the first aspect of the invention.*

A sixth aspect of the invention is *a computer program comprising instructions that, when executed by a computer system, cause the computer to perform any of the methods according to the first aspect of the invention.*

### DESCRIPTION OF THE DRAWINGS

These and other features and advantages of the invention will be seen more clearly from the following detailed description of a preferred embodiment provided only by way of illustrative and non-limiting example in reference to the attached drawings.
- Figure 1: This figure shows an example of a set of vector loads satisfying that an apparatus does not fail when an action according to any of the vector loads is applied.
- Figure 2: This figure shows a first convex domain using a subset of vector loads.
- Figure 3: This figure shows for each point, the vector load depicted as arrows departing from the origin and extended until the point defined by said vector load.
- Figure 4: This figure shows the result of the next step removing all vectors located within the calculated convex domain.
- Figure 5: This figure shows the grouping step for those remaining load vectors.
- Figure 6: This figure shows a first expansion step using a representative load step for each group.
- Figure 7: This figure shows the result of the expansion and the removal of all load vectors located within the calculated convex domain at this stage.
- Figure 8: This figure shows a further expansion step for two remaining load vectors.
- Figure 9: This figure shows a further embodiment wherein a threshold value is used for determining the distance between the point defined by a load vector and the hyper-face.
- Figure 10: This figure shows a further embodiment wherein a selected group of vectors are used to explore in specific directions locations out of the calculated convex hull in order to obtain a further extended convex hull and, the resulting convex hull if a threshold value is used.

### DETAILED DESCRIPTION OF THE INVENTION

As will be appreciated by one skilled in the art, aspects of the present invention may be embodied as a system, method or computer program product.

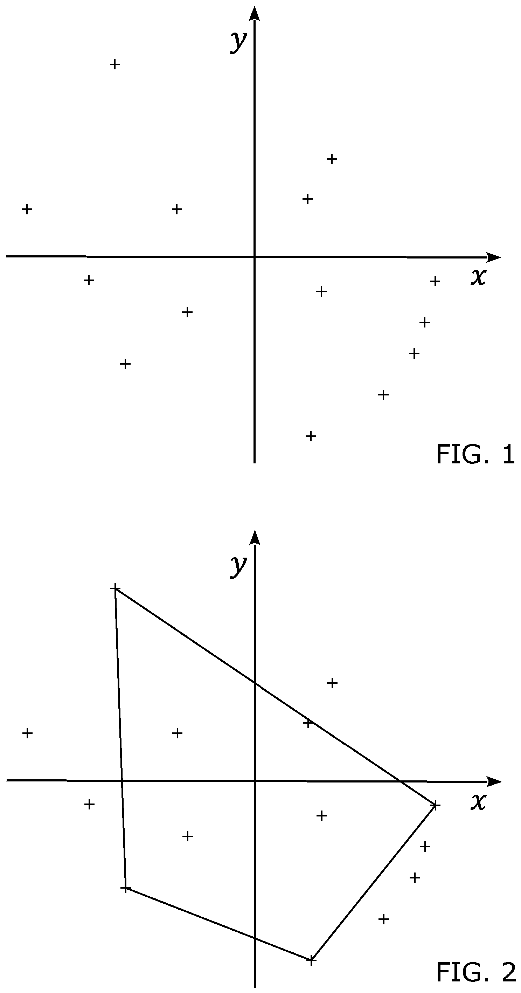

Figures 1 to 10 show a simple embodiment in two dimensions since, graphical representation in more dimensions may obscure the description of an example.

Thus, the load vectors will be vectors in ${ℝ}^{2}$, the convex domain will be a convex region in the X-Y plane and the hyper-faces will be represented by segments. Following this reasoning, the boundaries of the hyper-faces will be straight lines of the convex domain.

As shown in Figure 1, Figure 1 shows a set of points in a space of ${ℝ}^{2}$ where, each point, is defined by a load vector that satisfies that, an action applied on an apparatus under verification, does not fail. For this reason, defining a point in ${ℝ}^{2}$ is considered the same as defining a vector extending from the origin to that point.

The number of points is greater than 2, the dimension of the space ( ${ℝ}^{2}$) and in addition, since there are more than two vectors with different directions there are enough vectors to build an spanning set of vectors of ${ℝ}^{2}$ and, as a result the set of vectors has rank 2.

It is proposed to construct a domain in ${ℝ}^{2}$, convex, that satisfies that any point in the domain establishes load vectors that do not give rise to failure in the apparatus.

In Figure 2, according to an embodiment of the method of constructing a convex hull, a first convex domain of simple construction from a subset of load vectors is proposed. The resulting domain has been represented by a convex polygon.

The polygon is convex since, for any two distinct points of the polygon, any point on the line connecting the two points is a point either of the polygon or of the region inside the polygon.

The domain thus constructed contains four points that belong to the boundary, those that are defining the polygon, four points that are inner points, and six exterior points.

The inner points are no longer of interest for the moment since they are already in a first domain which verifies that all interior points are points in which there is no failure.

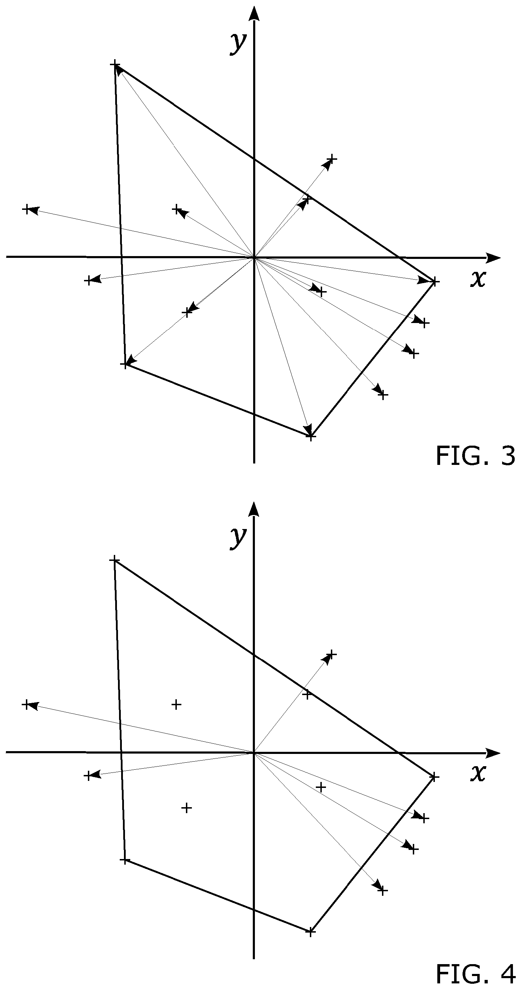

Figure 3 serves to show the equivalence between point and associated load vector, so that in this context it is equivalent to speak of point in ${ℝ}^{2}$ and load vector.

From this set of vectors, as shown in Figure 4, all those load vectors that are interior and therefore those that belong to the boundary are removed.

The vectors left out are vectors that should be in the interior of the convex domain to be calculated since they are vectors representing actions under which the apparatus does not fail.

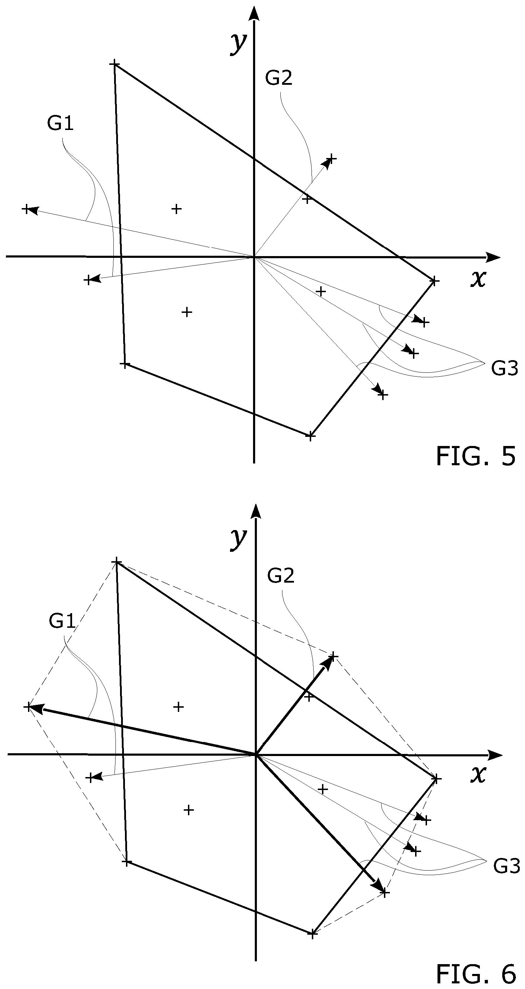

Continuing with the method, as shown in Figure 5, the exterior points are grouped where, for each group, the vectors satisfy that they intersect the same polygon line. From the most generic point of view, they are vectors intersecting the same hyper-face of the current convex domain.

In view of this grouping criterion, Figure 5 shows three distinct groups of vectors.

For each group of vectors, the distance between the vector and the polygon line is measured such that, for each group, the vector with the greatest distance is selected.

Figure 6 identifies the vector that meets this condition of greater distance by showing it with a greater thickness.

Likewise, this same figure shows the next step where the polygon line that defines the group will be removed and replaced by two lines that are represented in dashed lines.

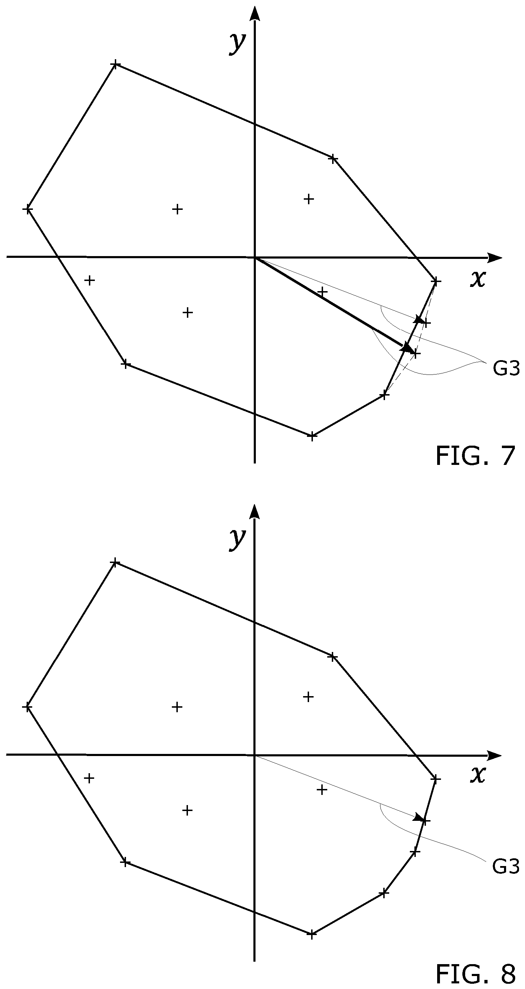

Figure 7 shows the next step where the lines defining the hyper-faces with vectors forming groups have been removed and replaced by the new lines expanding the previously calculated convex domain.

In the case of the group identified in the figure as G1, of the two vectors of the group, one establishes the expansion conditions of the domain in this line/hyper-face and, the other one being inside the domain is also removed.

In the group identified in the figure as G2, the only vector that was previously outside the domain has caused the expansion in its line/hyper-face and has also been removed.

In the group identified in the figure as G3 the situation is different. Once the expansion of the domain has been carried out by replacing the line/hyper-face by two
lines/hyper-faces connecting the vector of greater distance to the line/hyper-face with the vertices/boundaries of the line/hyper-face that is removed, two of the vectors that belonged to the same group continue verifying to be external to the expanded domain so the iterative method has not finished.

In this same figure 7 shows one of the two exterior arrows, where both intersect the same line of the polygon, of greater thickness and is the one that defines the next expansion of the domain. The expanded domain is again identified with two discontinuous lines that, in Figure 8, become the new boundaries of the convex domain.

Again, in view of Figure 8, the only vector represented is an exterior vector, which causes the iterative method not to be finished and causes a new expansion of the convex domain.

However, it is observed that the distance of this vector to the intersecting line/hyper-face is very small. Each computation of new lines/hyper-faces greatly increases the computer cost. In this case the expansion is very small.

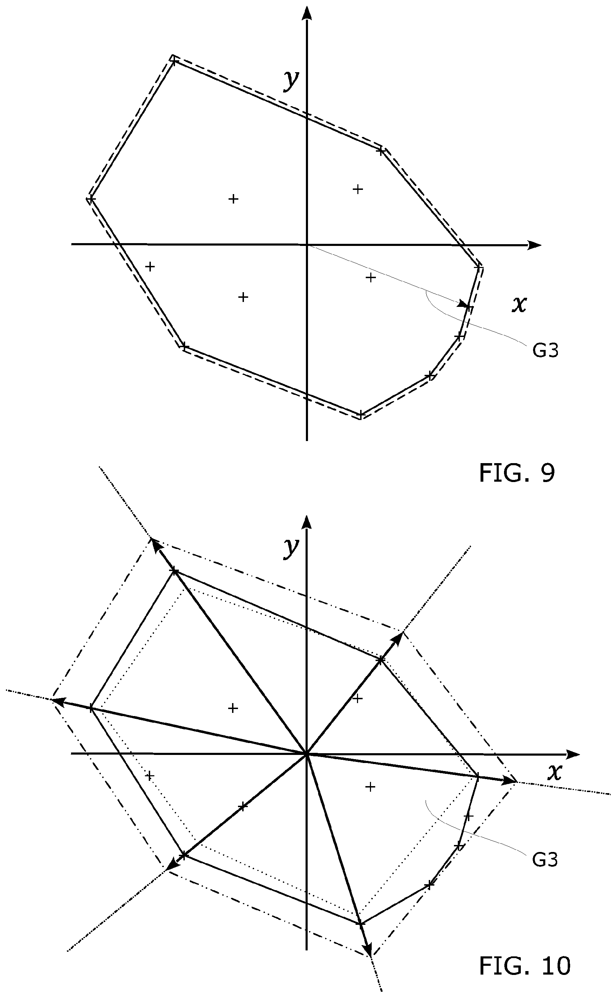

Figure 9 shows a more specific example where the measurement of the distance to the line/hyper-face causes an expansion if this distance is greater than a threshold value. This threshold value is equivalent to defining an expanded boundary and distanced the distance determined by the threshold value so that any vector falling within this region, shown in dashed line, is considered not to be external to the computed convex domain and, therefore, does not cause the computation of a new expansion.

When the iterative method has finished because there are no vectors left outside or, because the vectors are inside the domain defining the threshold value, the result is a convex hull that has inside it, or inside the domain expanded with the threshold value, all the vectors introduced at a start, those shown as points in Figure 1.

Figure 10 shows another specific example where, after having determined a convex hull, in this case the one resulting from the previous step taking into account the threshold value, values outside the calculated domain are explored that still verify to be convex.

The method selects a subset of vectors. In this specific embodiment, the vectors determining the vertices/boundaries of the domain have been chosen.

According to these vectors, a line is set to explore, the line defining the vector. This line is shown as a dotted line prolonging each of the vectors forming the vertices.

Instead of exploring the entire outer space, which would be unaffordable since each load vector gives rise to an experiment or a simulation that is usually very costly computationally, only conditions along these lines are explored. For this purpose, the point on the line from which the failure condition is verified is sought. This point is a point belonging to the unknown failure boundary.

Either this point is chosen or a point somewhat closer to the origin is chosen more conservatively by selecting a safety factor.

These points determine exterior vectors to the predetermined convex hull and, applying the expansion method already explained, a new convex hull is obtained as shown in lines combining traces and points.

Likewise, it is possible to establish a safety factor that gives rise to a convex hull of smaller dimensions and that, therefore, is more conservative since although there are values that do not give rise to failure outside these boundaries, represented with a dotted line, it is considered as safe the actions that respond to interior vectors to the new convex hull reduced with the safety factor.

## Claims

1. A computer implemented method for determining a failure condition for an apparatus subjected to load or action (*lₜ*) actuating on the apparatus the method comprising:
- inputting data into a computer system, the inputted data representing m known loads or actions (*l*) acting on the apparatus satisfying:
said m loads or actions (*l*) results in a status of non-failure,
said data being stored as set of m vectors ( ${v}_{j} ∈ {ℝ}^{n}$; *j* = 1, ..., m) and wherein n is the number of coordinates, each coordinate defining each scalar value of the individual load or action *(l);*
the number of vectors m is larger than n and, the rank of the set of vectors is *n;*
- computing by the computer system a domain ( $D ⊂ {ℝ}^{n}$) delimited by a safe convex hull defined by a plurality of hyperplanes, the convex hull calculated according to the following steps:
a) determining a first convex domain *(D̃),* preferably as an octahedron with hyper-faces defined by max-min points;
b) removing those vectors *(vⱼ)* located within the calculated convex domain *(D̃);*
c) grouping the set of vectors *(vⱼ)* that have not been removed in the previous step, one group per hyper-face delimiting the calculated convex domain *(D̃),* wherein each group (*Gⱼ*) comprises those vectors *(vⱼ)* which has intersection in the part of the hyper-face that belongs to the calculated convex domain *(D̃);*
d) for each group (*Gⱼ*), selecting the vector *(vⱼ)* which has the greatest distance to the corresponding hyper-face of the convex domain *(D̃)* and, replacing the corresponding hyper-face by a set of new hyper-faces passing through the point defined by the vector (*vᵢ*) of greatest distance and lying on the boundaries of the replaced corresponding hyper-face which belong to the calculated convex domain *(D̃)* before being substituted;
e) iterating from step b) until convergence, that is, until there are no more vectors *(vⱼ)* located outside of the calculated convex domain *(D̃),* and wherein the convex hull is the resulting calculated convex domain *D̃* after convergence;
- checking if the load or action (*lₜ*) lies within the convex hull determining a failure condition, where the status is deemed a non-failure condition if the load or action (*lₜ*) is within the convex hull, and a failure condition otherwise.

2. A method according to claim 1, wherein in step e), a vector *(vⱼ)* is located outside of the calculated convex domain *(D̃),* if the distance of the vector *(vⱼ)* to the closest hyper-face is higher than a predetermined threshold, preferably of 20%, preferably of 10%, more preferably of 5%, more preferably of 3%, more preferably of 2% and more preferably of 1%.

3. A method according to claim 1 or 2, wherein the inputted data representing m known loads or actions (*l*) acting on the apparatus are retrieved from:
- measurements;
- results of simulations;
- a data base storing any of the two former sources;
- a combination of any of the previous one.

4. A method according to any of previous claims, further comprising:
- instantiating into the computer system a simulation module implementing a numerical model adapted to simulate the behavior of at least one part of the apparatus, the module providing at least one status variable responsive to a failure condition of the simulated apparatus when subjected to a load or action (*l*);
- inputting one or more loads or actions (*l*);
- simulating the behavior of the at least one part of the apparatus subjected to the inputted one or more loads or actions (*l*) by means of the simulation module;
- providing those loads or actions resulting in a non-failure condition as inputted data for determining the convex hull.

5. A method according to any of previous claims, wherein the convex hull is expanded by carrying out the steps:
v. a ratio is defined as $Rt \left({v}_{j}\right) = \frac{\left‖{v}_{j}\right‖}{\left‖{v}_{j}^{fail}\right‖}$ wherein ∥·∥ is a predetermined norm, *vⱼ* is a load and ${v}_{j}^{fail}$ is a load having the same direction as *vⱼ* such that $\left‖{v}_{j}^{fail}\right‖ = \left‖{λ}_{0}{v}_{j}\right‖$ for *λ*₀ a scalar value satisfying that vectors λ*vⱼ* for *λ* > *λ*₀ results in a fail status condition and, for *λ* ≤ *λ*₀ results in a non-fail status condition, that is, *Rt*(*vⱼ*) is less or equal than 1 when the load does not cause a failure and greater than 1 when the load causes a failure.;
vi. selecting a subset of *k* vectors (*vₖ*) among the m vectors (*vⱼ*);
vii. for each selected vector (*vₖ*) determining a new vector (*vₖ*) satisfying that *Rt*(*ṽₖ*) = *λ** and that *ṽₖ* = *λvₖ* being *λ* a non zero scalar, wherein A* is 1, or more preferably 1 minus a positive predetermined threshold;
viii. replacing *vₖ* by *ṽₖ* and further expanding the convex hull by iterating steps b) to e).

6. A method according to any previous claim, wherein before step a), carrying out steps ii) iv) and, replacing *vₖ* by *ṽₖ*.

7. An apparatus designed to be subjected to loads or actions (*lₜ*) actuating on the apparatus, tested according to any of methods 1 to 6, and satisfying that the status of the tested design is 'non-failure'.

8. An apparatus, preferably an aircraft, comprising an alarm device adapted to carry out continuous sampling of the loads or actions (*lₜ*) acting on the apparatus, where the alarm device is activated when such loads or actions (*lₜ*) are located outside the convex hull determined by a method according to any one of the claims 1 to 6.

9. Apparatus manufactured according to the tested design of claim 7, provided the status of the tested design is 'non-failure'.

10. A computer system adapted to carry out any of claims 1 to 5.

11. A computer program comprising instructions that, when executed by a computer system, cause the computer to perform any of the methods of claims 1 to 5.
